# EUROPÄISCHE PATENTANMELDUNG

(11) **EP 0 740 335 A2**
(43) Veröffentlichungstag der Anmeldung: **30.10.1996**
(21) Anmeldenummer: 96106260.1
(22) Anmeldetag: 19.04.1996
(51) Int. Cl.: H01L 21/331, H01L 21/8249

(54) **SOI-BiCMOS-Verfahren**

(30) Priorität: 28.04.1995 DE 19515797
(71) Anmelder: SIEMENS AKTIENGESELLSCHAFT, 80333 München (DE)
(72) Erfinder: Kerber, Martin, Dr., 81827 München (DE)

(57) **Zusammenfassung**

Herstellungsverfahren für laterale Bipolartransistoren auf SOI-Substrat, bei dem auf eine mit einer Grunddotierung versehene Mesa (3) eine stegförmige Gate-Elektrode (8/9) aufgebracht und ganzflächig mit einer TEOS-Schicht (10) mit als Spacer (11, 12) fungierenden vertikalen Anteilen an den Flanken dieser Gate-Elektrode bedeckt wird. Unter Verwendung von Lackmasken (13, 14) werden Dotierstoffe für einen Kollektor-Bereich (4) und einen Emitter-Bereich (6) eingebracht. Die Basisimplantierung erfolgt nach dem Entfernen der TEOS-Schicht (10) im Bereich des Spacers (11) längs eines Randes der Gate-Elektrode.

## Beschreibung

Die vorliegende Erfindung betrifft ein Herstellungsverfahren für laterale Bipolartransistoren, das mit der CMOS-Technologie kompatibel ist.

In der Veröffentlichung IEDM 92, 453 bis 456 ist ein Verfahren beschrieben, mit dem laterale Bipolartransistoren auf einem SOI-Substrat hergestellt werden. Dabei wird zunächst in der Body-Siliziumschicht eine Mesa hergestellt und mit einer Oxidschicht überzogen. Für die komplementären Transistoren werden jeweils gesonderte Mesas hergestellt, die mit einer jeweiligen Grunddotierung, n-leitend bzw. p-leitend, versehen werden. Mittels einer ganzflächig aufgebrachten und anschließend strukturierten Polysiliziumschicht werden stegförmige Gate-Elektroden hergestellt, die anschließend als Implantationsmaske für Dotierstoff für den jeweiligen Basisbereich verwendet werden. Mit einem geeigneten Temperschritt wird erreicht, daß der hierbei zunächst anisotrop eingebrachte Dotierstoff seitlich unter den von der Gate-Elektrode abgedeckten Bereich ausdiffundiert und so den für die Basis vorgesehenen Bereich bildet. Mittels einer weiteren anisotropen Implantierung werden die Dotierungen für den Emitter- und Kollektorbereich eingebracht. Dabei bleibt unter der Gate-Elektrode zwischen dem Basisbereich und dem Kollektorbereich ein niedriger dotierter Übergangsbereich. Für die verschiedenen Anschlußbereiche und die Gate-Elektrode werden dann noch Anschlüsse hergestellt.

Aufgabe der vorliegenden Erfindung ist es, ein Herstellungsverfahren für laterale Bipolartransistoren anzugeben, das besser in den CBiCMOS-Prozeß integriert werden kann.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren wird eine Grunddotierung für den Kollektor zwischen Basis und Kollektoranschlußbereich verwendet. Die an den Flanken einer stegförmigen Gate-Elektrode vorhandenen vertikalen Anteile einer ganzflächigen Dielektrikumschicht werden als Spacer verwendet, um zunächst den Dotierstoff für den Emitterbereich einzubringen und nach Entfernen dieser Dielektrikumschicht den Basisbereich zu implantieren.

Es folgt eine Beschreibung des erfindungsgemäßen Verfahrens anhand der Figuren 1 bis 5.
- Figuren 1 bis 4: zeigen Querschnitte des erfindungsgemäß hergestellten Bipolartransistors nach verschiedenen Schritten des Verfahrens.
- Figur 5: zeigt in Aufsicht im Schema die Anordnung der verschiedenen dotierten Bereiche.

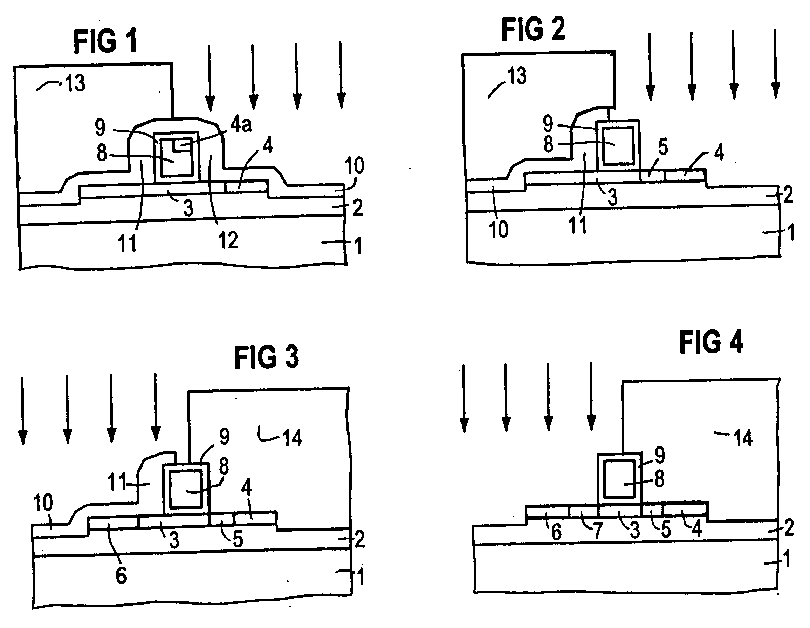

Bei diesem Verfahren wird z. B. entsprechend einem CMOS-Prozeß auf SOI-Substrat in der Body-Siliziumschicht ein begrenzter Bereich ringsum elektrisch isoliert. Das kann z. B. mittels einer lokalen Oxidation (LOCOS) oder durch Ausätzen einer Mesa geschehen. Eine Gate-Elektrode z. B. aus Silizium wird aufgebracht und z. B. stegförmig strukturiert. Üblicherweise wird danach eine Oxidation durchgeführt, mit der eine dünne Oxidschicht hergestellt wird, die diese Gate-Elektrode an den Oberseiten und den Seitenflächen bedeckt. In Figur 1 ist ein SOI-Substrat mit einer Bulk-Siliziumschicht 1, einer Isolatorschicht 2 und der in der Body-Siliziumschicht hergestellten und mit einer Grunddotierung für den Leitungstyp von Emitter und Kollektor versehenen Mesa dargestellt. Die Gate-Elektrode 8 ist mit der dünnen Oxidschicht 9 versehen. Es wird dann ganzflächig eine Dielektrikumschicht, z. B. TEOS (Tetraethyloxysilikat), als Hilfsschicht 10 abgeschieden. An den Flanken der Gate-Elektrode 8 befinden sich von dieser Hilfsschicht 10 vertikale Anteile, die in folgenden Verfahrensschritten als Spacer 11, 12 verwendet werden. Bei dem dargestellten Ausführungsbeispiel befindet sich der linke Spacer 11 in der Zeichnung auf der Seite der herzustellenden Basis, während der rechte Spacer 12 sich über dem Kollektorbereich befindet. Es wird dann entsprechend den eingezeichneten Pfeilen unter Verwendung einer Maske 13 Dotierstoff eingebracht, der von dem jeweiligen vertikalen Anteil der Hilfsschicht 10 abgeschirmt wird. Bei dem gezeigten Ausführungsbeispiel wird zunächst der Kollektorbereich hergestellt, so daß Dotierstoff durch den rechten Spacer 12 abgeschirmt wird. Durch die horizontalen Anteile der Hilfsschicht 10 hindurch gelangt der Dotierstoff in die Mesa, um dort den Kollektorbereich 4 auszubilden. Der Anteil des Dotierstoffes, der in das Material der Gate-Elektrode gelangt, ist als Bereich 4a eingezeichnet. Der Übersichtlichkeit halber werden in den nachfolgenden Figuren die bei den Implantationsschritten entstehenden dotierten Bereiche in der Gate-Elektrode weggelassen. Bei einer n-leitenden Grunddotierung in der Mesa 3 kann das Silizium des Kollektorbereiches z. B. mittels Arsen n-leitend dotiert werden. In dem von der Maske 13 frei gelassenen Bereich wird dann die Hilfsschicht 10 entfernt und erneut Dotierstoff, z. B. Phosphor, eingebracht, um die niedriger dotierten Kollektorbereiche 5 herzustellen. Dieser Verfahrensschritt kann ggf. weggelassen werden, er empfiehlt sich aber, wenn zusammen mit dem Bipolartransistor MOSFETs hergestellt werden und für diese MOSFETs die Herstellung von niedriger dotierten Übergangsbereichen zwischen Drain und Kanalbereich vorgesehen ist. Der entsprechende Implantationsschritt kann dann gleichzeitig für den in Figur 2 dargestellten Implantationsschritt zur Herstellung des Kollektorbereiches 5 eingesetzt werden.

In den Figuren 3 und 4 ist die Herstellung der Emitter- und Basisbereiche dargestellt. Dieser Abschnitt des Verfahrens kann genauso gut vor der Herstellung des Kollektorbereiches erfolgen. Durch die Hilfsschicht 10 hindurch wird der Emitterbereich 6 implantiert, wobei der vertikale Anteil der Hilfsschicht 10 als Spacer 11 den für die Basis vorgesehenen Bereich abschirmt. Bei einer n-leitenden Grunddotierung zur Herstellung eines npn-Transistors kann als Dotierstoff für den Emitter z. B. Arsen verwendet werden. Anschließend wird die Hilfsschicht 10 entfernt. Dabei kann man die Eigenschaft nutzen, daß TEOS deutlich schneller geätzt wird als das die Gateelektrode umgebende thermische Oxid 9, so daß dieses einen ausreichenden Ätzstopp bietet. Dann wird eine Implantierung für den entgegengesetzten Leitfähigkeitstyp eingebracht. Die Dosis dieser Implantierung wird dabei so eingestellt, daß entsprechend Figur 4 der Basisbereich 7 seitlich an die Gate-Elektrode angrenzend hergestellt wird, aber das Vorzeichen der Dotierung des Emitterbereiches nicht umgekehrt wird. In der Mesa 3 befindet sich entsprechend der Figur 4 danach eine Abfolge aus einem hoch dotierten Emitter-Bereich 6, einem entgegengesetzt dotierten Basis-Bereich 7, den niedrig dotierten Kollektorbereichen 3, 5, von denen der an die Basis angrenzende Kollektorbereich 3 noch die ursprüngliche Grunddotierung aufweist, und dem hoch dotierten Kollektor-Bereich 4. Die bei diesen Implantierungsschritten für Emitter und Basis verwendete Maske 14 wird anschließend entfernt.

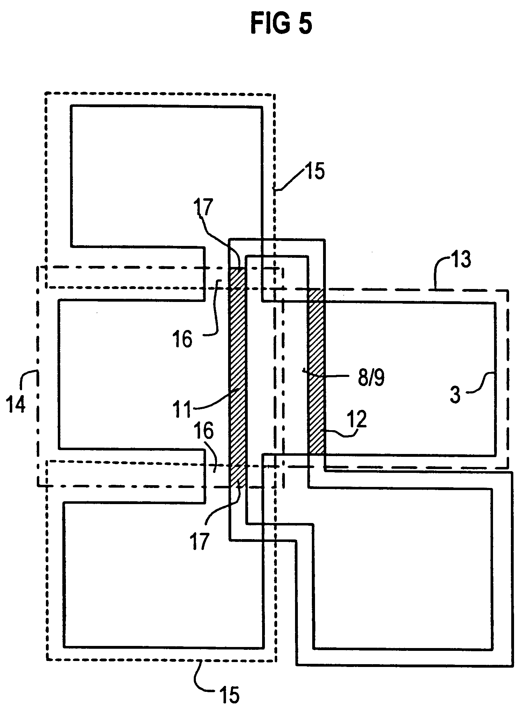

Figur 5 zeigt die Anordnung der dotierten Bereiche im Schema in einer Aufsicht. Es sind die Berandungen der Mesa 3 und der für die Gate-Elektrode 8/9 aufgebrachten Schicht eingezeichnet. Von der Hilfsschicht 10 sind nur die an den Flanken der Gate-Elektrode vorhandenen vertikalen Anteile als Verdoppelung der Berandung eingezeichnet und speziell die als Spacer 11, 12 fungierenden Bereiche hervorgehoben. Die Öffnung der in den in Figuren 1 und 2 dargestellten Schritten verwendeten Maske 13 ist mit der gestrichelten Linie eingezeichnet. Dieser in diesem Beispiel rechteckige Bereiche entspricht dem Bereich der Implantierung des Kollektors. Die Öffnung der in den in Figuren 3 und 4 dargestellten Schritten verwendeten Maske 14 ist strichpunktiert eingezeichnet. Nach der Implantierung von Emitter und Basis wird in den Basisanschlußbereichen der Mesa unter Verwendung einer weiteren Maske 15, die mit gepunkteten Umrandungen eingezeichnet ist, eine Dotierung für elektrische Leitung des Leitungstyps der Basis (hier z. B. p-Leitung) für eine hohe Dotierungsdichte eingebracht. Bei der in Figur 5 eingezeichneten Überschneidung der Öffnungen der Maske 14 und der Maske 15 ergeben sich die Übergangsbereiche 16 zwischen Basis und Emitter, in denen die Dotierung des Emitters jeweils von der hohen Dotierung der Basisanschlußbereiche überkompensiert ist. Der in dem Schritt der Figur 2 hergestellte Kollektorbereich 5 und der in dem in Figur 4 dargestellten Schritt hergestellte Basisbereich 7 sind in Figur 5 schraffiert eingezeichnet. Die Endbereiche 17 des Basisbereiches sind höher dotiert als der Rest des Basisbereiches, weil zu der Basisdotierung hier die hohe Dotierung der Basisanschlußbereiche hinzukommt. In analoger Weise werden die pnp-Transistoren hergestellt, wobei lediglich mit einer weiteren Lackmaske und entsprechend vertauschten Implantationen deren Emitter- und Basisbereiche realisiert werden.

Für den Fall, daß die Hilfsschicht 10 über dem herzustellenden Emitterbereich zu dick ist, um eine ausreichend hohe Dotierung zu ermöglichen, kann diese Hilfsschicht 10 unmittelbar nach dem Abscheiden oder Aufbringen der Lackmaske anisotrop kontrolliert rückgeätzt werden. Dadurch bleibt die Spacerwirkung der vertikalen Anteile erhalten, die wirksame Dicke des Streuoxids in den herzustellenden Anschlußbereichen von Emitter und Kollektor wird aber reduziert, was eine flachere Implantation zuläßt. Für den Fall, daß im Übergangsbereich 16 zwischen dem Emitteranschluß und dem Basisanschlußbereich als Folge der relativ hohen Konzentrationen der Dotierstoffe die Spannungsfestigkeit des Emitter-Basis-Überganges nicht ausreicht, kann für die Implantierung des Emitters eine eigene Lackmaske vorgesehen werden, deren Öffnung nicht mit der Öffnung der für die Dotierung der Basisanschlußgebiete vorgesehenen Maske 15 überlappt. Bei einer Integration des erfindungsgemäßen Verfahrens in einen CMOS-Prozeß, bei dem komplementäre MOSFETs hergestellt werden, wird zusammen mit der Implantation des Basisanschlußbereiches des Bipolartransistors der Drain-Bereich der jeweils dem Vorzeichen der Leitfähigkeit entsprechenden MOSFETs hergestellt. Die Drain-Bereiche der dazu komplementären MOSFETs werden wie erwähnt in dem in den Figuren 1 und 2 dargestellten Verfahrensschritt zur Herstellung des Kollektorbereiches hergestellt. Mit dem erfindungsgemäßen Verfahren ist daher eine weitgehende Integration des Herstellungsverfahrens lateraler Bipolartransistoren sowohl des npn- als auch des pnp-Typs in den CMOS-Prozeß möglich.

## Patentansprüche

1. Verfahren zur Herstellung eines lateralen Bipolartransistors, bei dem
a) eine Halbleiterschicht (3) lateral isoliert und mit einer Grunddotierung für elektrische Leitung eines ersten Leitfähigkeitstyps versehen wird,
b) angrenzend an einen für einen Basisbereich vorgesehenen Bereich auf diese Halbleiterschicht eine streifenförmige Gate-Elektrode (8) aufgebracht wird,
c) über dieser Halbleiterschicht und dieser Gate-Elektrode eine Dielektrikumschicht (10) aufgebracht wird,
d) die untenstehenden Schritte e bis h in der Reihenfolge, in der sie aufgeführt sind, die untenstehenden Schritte i bis l in der Reihenfolge, in der sie aufgeführt sind, und nach Schritt l die untenstehenden Schritte m und n nacheinander erfolgen,
e) unter Verwendung einer Maske (13) mit einer Öffnung, die bezüglich der Ebene dieser Halbleiterschicht lateral neben dieser Gate-Elektrode auf der von diesem für einen Basisbereich vorgesehenen Bereich abgewandten Seite und mindestens bis an einen von der Gate-Elektrode eingenommenen Bereich heranreichend vorhanden ist, ein Dotierstoff für elektrische Leitung dieses ersten Leitfähigkeitstyps in diese Halbleiterschicht eingebracht wird,
f) im Bereich dieser Öffnung dieser Maske (13) diese Dielektrikumschicht entfernt wird,
g) erneut ein Dotierstoff für elektrische Leitung dieses ersten Leitfähigkeitstyps in diese Halbleiterschicht eingebracht wird und
h) diese Maske (13) entfernt wird,
i) unter Verwendung einer Maske (14) mit einer Öffnung, die bezüglich der Ebene dieser Halbleiterschicht lateral neben dieser Gate-Elektrode auf der diesem für einen Basisbereich vorgesehenen Bereich zugewandten Seite und mindestens bis an einen von der Gate-Elektrode eingenommenen Bereich heranreichend vorhanden ist, ein Dotierstoff für elektrische Leitung dieses ersten Leitfähigkeitstyps in diese Halbleiterschicht eingebracht wird,
j) mindestens in dem für diesen Basisbereich vorgesehenen Bereich diese Dielektrikumschicht entfernt wird,
k) unter Verwendung einer Maske (14) ein Dotierstoff für elektrische Leitung des diesem ersten Leitfähigkeitstyp entgegengesetzten zweiten Leitfähigkeitstyps in diesen Bereich eingebracht wird, wobei die Höhe dieser Dotierung so gewählt wird, daß auf der von dieser Gate-Elektrode abgewandten Seite dieses Bereiches die Dotierung für elektrische Leitung des ersten Leitfähigkeitstyps überwiegt,
l) die in Schritt k verwendete Maske (14) entfernt wird,
m) unter Verwendung einer weiteren Maske (15), die eine Öffnung in einem für eine Basisanschlußzone vorgesehenen Bereich hat, ein Dotierstoff für elektrische Leitung des zweiten Leitfähigkeitstyps in diese Halbleiterschicht eingebracht wird,und
n) diese weitere Maske entfernt wird.

2. Verfahren nach Anspruch 1, bei dem in Schritt k dieselbe Maske verwendet wird wie in Schritt i.

3. Verfahren nach Anspruch 1, bei dem
in Schritt i eine Maske verwendet wird, deren Öffnung auf den von der in Schritt m verwendeten weiteren Maske abgedeckten Bereich begrenzt ist, und
zwischen Schritt i und Schritt j die in Schritt i verwendete Maske entfernt und vor dem Schritt k durch eine für den Schritt k vorgesehene Maske ersetzt wird.

4. Verfahren nach einem der Ansprüche 1 bis 3, das zur gleichzeitigen Herstellung eines MOSFETs eingesetzt wird und bei dem
in Schritt b auch mindestens eine für einen MOSFET vorgesehene Gate-Elektrode aufgebracht wird und
mindestens in einem der Schritte e, i und m auch eine Dotierung für einen Drain-Bereich eines MOSFETs eingebracht wird.

5. Verfahren nach Anspruch 4, bei dem
in Schritt e auch eine Dotierung für einen Drain-Bereich eines MOSFETs eingebracht wird und
in Schritte g auch eine Dotierung für einen niedriger dotierten Übergangsbereich zwischen diesem Drain-Bereich und einem für denselben MOSFET vorgesehenen Kanal-Bereich eingebracht wird.

6. Verfahren nach Anspruch 4 oder 5, mit dem als BiCMOS-Verfahren komplementäre MOSFETs hergestellt werden und bei dem mindestens in einem der Schritte e und i auch eine Dotierung für einen Drain-Bereich eines MOSFETs eingebracht wird und in Schritt m auch eine Dotierung für einen Drain-Bereich eines komplementären MOSFETs eingebracht wird.

7. Verfahren nach einem der Ansprüche 1 bis 6, bei dem Bipolartransistoren eines ersten Typs und eines dazu komplementären zweiten Typs hergestellt werden, indem
o) die Schritte a bis c für die herzustellenden Bipolartransistoren gemeinsam erfolgen und dabei die Grunddotierung jeweils mit dem Leitfähigkeitstyp von Emitter und Kollektor des herzustellenden Typs hergestellt wird,
p) für den ersten Typ von herzustellenden Transistoren die Folge von Schritten d durchgeführt wird,
q) für den zweiten Typ von herzustellenden Transistoren eine Folge von Schritten durchgeführt wird, die der Folge von Schritten d mit jeweils vertauschten Leitfähigkeitstypen entspricht, und
in der Folge von Schritten p der Schritt m so ausgeführt wird, daß damit gleichzeitig ein dem Schritt e oder dem Schritt i entsprechender Schritt der Folge von Schritten q mit Dotierstoff für den zweiten Leitfähigkeitstyp erfolgt.

8. Verfahren nach Anspruch 7, rückbezogen auf Anspruch 5, mit dem als CBiCMOS-Verfahren komplementäre MOSFETs hergestellt werden, bei dem
in der Folge von Schritten q der dem Schritt e mit Dotierstoff für den zweiten Leitfähigkeitstyp entsprechende Schritt so ausgeführt wird, daß damit gleichzeitig auch eine Dotierung für einen Drain-Bereich eines MOSFETs eingebracht wird und
in der Folge von Schritten q der dem Schritt g mit Dotierstoff für den zweiten Leitfähigkeitstyp entsprechende Schritt so ausgeführt wird, daß damit gleichzeitig auch eine Dotierung für einen niedriger dotierten Übergangsbereich zwischen diesem Drain-Bereich und einem für denselben MOSFET vorgesehenen Kanal-Bereich eingebracht wird.
